## Europäisches Patentamt

## European Patent Office

## Office européen des brevets

(11) Veröffentlichungsnummer: **0 050 201**
**B1**

(12) # EUROPÄISCHE PATENTSCHRIFT

(45) Veröffentlichungstag der Patentschrift:
22.02.84

(51) Int. Cl.³: **H 03 J 1/06**

(21) Anmeldenummer: **81106474.0**

(22) Anmeldetag: **20.08.81**

(54) **Drucktastenaggregat.**

(30) Priorität: **18.10.80 DE 3039401**

(43) Veröffentlichungstag der Anmeldung:
**28.04.82 Patentblatt 82/17**

(45) Bekanntmachung des Hinweises auf die Patenterteilung:
**22.02.84 Patentblatt 84/8**

(84) Benannte Vertragsstaaten:
**FR GB IT**

(56) Entgegenhaltungen:
**DE - A - 2 833 184**
**US - A - 3 308 382**
**US - A - 3 828 285**
**US - A - 3 866 477**

(73) Patentinhaber: **PREH, Elektrofeinmechanische Werke Jakob Preh Nachf. GmbH & Co.,**
**Postfach 1740 Schweinfurter Strasse 5, D-8740 Bad Neustadt/Saale (DE)**

(72) Erfinder: **Bauer, Karl-Heinz, Lerchenstrasse 9, D-8740 Bad Neustadt / Saale (DE)**
Erfinder: **Eckert, Gerold, Am Bersbach 16, D-8740 Bad Neustadt/Saale (DE)**
Erfinder: **Labude, Wolfgang, Ing. grad., Halde 9, D-7750 Konstanz 19 (DE)**

## Drucktastenaggregat

Die Erfindung geht von einem Drucktastenaggregat nach dem Oberbegriff des Anspruches 1 aus.

Derartige Drucktastenaggregate werden in verschiedenen Ausführungsformen bevorzugt bei der Abstimmung und Einschaltung von HF-Empfängern, wie z. B. Fernsehempfängern, eingesetzt. Durch einen einzigen Tastendruck kann jeweils die voreingestellte Abstimmspannung und damit die zugeordnete Station bzw. der Kanal eingeschaltet werden. Die Speicherung der eingestellten Abstimmspannung erfolgt in Kanalspeichern in der Form von als Spannungsteiler geschalteten Spindelwiderständen oder Drehwiderständen. Die Kanalspeicher und deren Anzeigemittel sowie eventuell zur Frequenzbereichsvorwahl vorgesehene Einstellorgane brauchen und sollen im Normalbetrieb des Gerätes nicht unmittelbar zugänglich sein, da sie leicht zu einer unwissentlichen oder unbeabsichtigten Fehlbedienung des Gerätes führen können. Außerdem kann bei zunehmender Zahl der Druckdrehknöpfe das Aussehen des Gerätes ungünstig beeinflußt werden. Man ist daher dazu übergegangen, die Einstellorgane in Vertiefungen des Gehäuses unterzubringen und diese Vertiefungen durch Abdeckungen in der Form von Klapptüren zu verschließen. Es besteht ferner der Trend, möglichst viele Druckdrehknöpfe zur Verfügung zu haben. Andererseits ist der auf der Frontseite der Fernsehempfänger vorhandene Platz meist sehr beschränkt. Dies bedeutet letztlich, daß der Abstand der Druckdrehknöpfe immer kleiner wird. Der seitliche Abstand kann aber ein bestimmtes Maß nicht unterschreiten, da die im gedrückten Zustand tief liegenden Einstellorgane, die ja gleichzeitig auch zur Abstimmung dienen, noch bequem mit den Fingern gedreht werden sollen. Um den seitlichen Abstand trotzdem noch verringern zu können, hat man den Einsatz eines Hilfsmittels in der Form eines Steckschlüssels vorgesehen.

Aus der DE-OS 2 833 184 ist bereits ein Drucktastenaggregat bekannt, bei dem ein solcher Steckschlüssel vorhanden ist. Dieser ist einstückig aus Kunststoff hergestellt und auf der Innenseite einer Klapptür mittels einer Halterung befestigt. Der Steckschlüssel besitzt ein mit einem kreuzförmigen Profil versehenes Ende, während das andere Ende demgegenüber im Durchmesser geringfügig stärker ist. Dieses Ende ist geriffelt, um ein bequemeres Verdrehen zu ermöglichen. Ist die Klapptür geschlossen, so befindet sich der Steckschlüssel mit seiner Halterung im Raum der Vertiefung, der über den Einstellorganen für die Frequenzbereichsvorwahl liegt. Gleichzeitig mit der Klapptür kann ein AFC-Schalter betätigt werden. Dieser Schalter besitzt zwei Raststellungen. Wird die Klapptür geschlossen, so wird der AFC-Schalter eingeschaltet. Ist die Klapptür jedoch offen, so muß zur Kanaleinstellung der AFC-Schalter zunächst von Hand ausgeschaltet werden. Es gibt jedoch auch Drucktastenaggregate, bei denen der AFC-Schalter als Taster ausgebildet ist, so daß mit dem Öffnen der Klapptür automatisch der AFC-Schalter ausgeschaltet wird. Da das Gehäuse des AFC-Schalters sich auf der Rückseite des Rahmengehäuses befindet, wird der Abstand AFC-Schaltergehäuse/Klapptür durch einen Stößel überbrückt. Dieser Stößel ist fest mit dem Kontaktschieber des AFC-Schalters verbunden.

Aufgabe der vorliegenden Erfindung ist es, ein Drucktastenaggregat nach der eingangs genannten Art zu schaffen, bei dem unter Einsparung eines Bauteils und damit geringeren Herstellungskosten eine bequemere und genauere Einstellung der Abstimmspannung und eine sichere Ausschaltung des AFC-Schalters möglich ist.

Diese Aufgabe wird erfindungsgemäß durch das im kennzeichnenden Teil des Patentanspruches 1 angegebene Merkmal gelöst.

Weitere vorteilhafte Ausgestaltungen der Erfindung sind den Unteransprüchen zu entnehmen.

Durch die gleichzeitige Verwendung des Schaltstößels als Hilfsmittel zum Drehen der Druckdrehknöpfe, entfällt ein eigener Steckschlüssel. Dies bringt neben einer Materialeinsparung noch den Vorteil, daß, um die Druckdrehknöpfe drehen zu können, der Schaltstößel herausgenommen werden muß, so daß während der Abstimmung der AFC-Schalter mit Sicherheit ausgeschaltet ist. Damit ist auch für einen Nichtfachmann, der die Zusammenhänge zwischen AFC-Schalter und Abstimmung nicht kennt, eine sichere Einstellung der Abstimmspannung gewährleistet. Ferner ist von Vorteil, daß der Betätigungskopfteil einen wesentlich größeren Durchmesser aufweist als die bekannten Steckschlüssel, so daß damit ein bequemeres und genaueres Einstellen der Abstimmspannung möglich ist. Ein Steckschlüssel mit gleichem Durchmesser könnte aus Platzgründen weder an der Klapptür noch viel weniger in der Vertiefung, die mit einem Jalousieband verdeckt ist, untergebracht werden.

Einzelheiten der Erfindung werden nachfolgend für zwei Beispiele anhand der Zeichnungen näher beschrieben.

Von den Figuren zeigt

Fig. 1 eine Vorderansicht eines Drucktastenaggregates,

Fig. 2 eine Seitenansicht des Drucktastenaggregates teilweise im Schnitt,

Fig. 3 eine perspektivische Seitenansicht des Drucktastenaggregates mit dem AFC-Schalter in Stellung EIN,

Fig. 4 eine perspektivische Seitenansicht des Drucktastenaggregates mit dem AFC-Schalter in Stellung AUS,

Fig. 5 einen vergrößerten Ausschnitt einer im Schnitt dargestellten Seitenansicht des Drucktastenaggregates mit einem Schaltstößel für den AFC-Schalter in Stellung EIN,

Fig. 6 einen vergrößerten Ausschnitt einer im Schnitt dargestellten Seitenansicht des Drucktastenaggregates mit einem um 180 Grad gedreht eingesteckten Schaltstößel,

Fig. 7 eine perspektivische Ansicht des Schaltstößels und des Jalousiebandes.

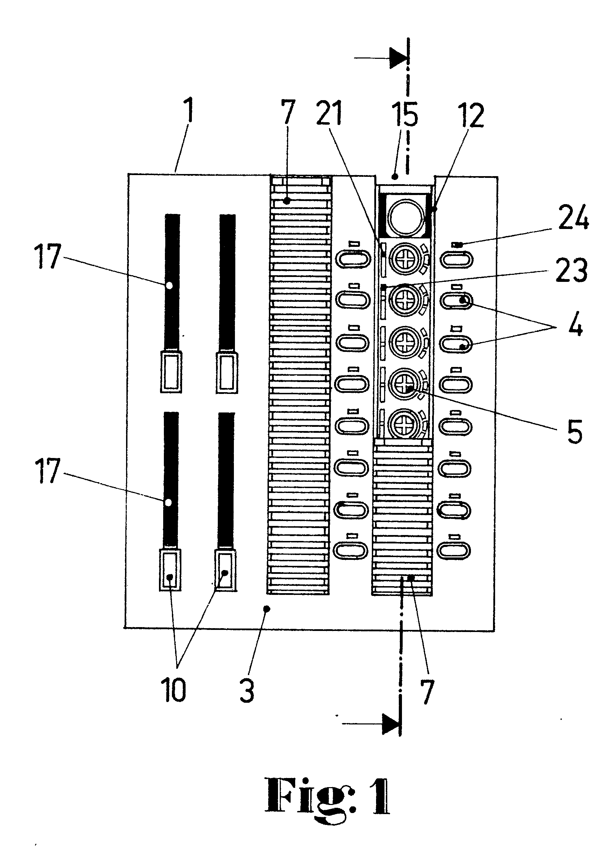

Das in Fig. 1 dargestellte und mit 1 bezeichnete Drucktastenaggregat besitzt zwei Reihen zu je acht mittels einer Sperrschiene gegenseitig auslösbaren Drucktasten 4 zur Einschaltung der in den einzelnen Kanalspeichern voreingestellten Abstimmspannungen. Es ist selbstverständlich auch eine hiervon abweichende Anzahl von Drucktasten denkbar. Das Drucktastenaggregat selbst besteht aus einem Gehäuse mit einem Speichergehäuse 18 und mit einer Gehäusefrontseite 3, in dem Einstell-, Schalt- und Anzeigeorgane zu einer Baueinheit zusammengefaßt sind.

Bei dem in Fig. 1 dargestellten Ausführungsbeispiel bestehen die einzelnen Einstellorgane für die Lautstärke, Bildhelligkeit, Kontrast usw. aus mehreren Schiebewiderständen 17, die seitlich zu den Drucktastenreihen angeordnet sind. Anstelle der Schiebewiderstände können auch Drehwiderstände Verwendung finden. Es ist hierbei selbstverständlich, daß die Anordnung der Einstellorgane, seien es nun Schiebe- oder Drehwiderstände, auch ober- oder unterhalb der Drucktastenreihe möglich ist.

Die hier verwendeten Schiebewiderstände bestehen in bekannter Weise aus einem Widerstandselement und einer Kollektorbahn. Beide werden elektrisch überbrückt durch eine Schleifkontaktfeder aus Metall, die an einem Federträger befestigt ist. Dieser Federträger kann in einem Widerstandsgehäuse geführt sein, das seinerseits an der Gehäusefrontseite befestigt ist. Dies hat den Vorteil, daß das Widerstandsgehäuse auch getrennt als eine Baueinheit Verwendung finden kann. Von dem Federträger ragt ein Ansatz durch den Schlitz der Gehäusefrontseite 3, wobei das freie Ende des Ansatzes als Federzungen ausgebildet ist, auf die ein Bedienungsknopf 10 aufgeschnappt ist.

Als Schaltorgane kann — falls erforderlich — zusätzlich ein Netzschalter in der Gehäusefrontseite befestigt werden. Auch dieser Netzschalter besitzt zweckmäßigerweise ein eigenes Netzschaltergehäuse, so daß er für sich allein als eigene Baueinheit eingesetzt werden kann.

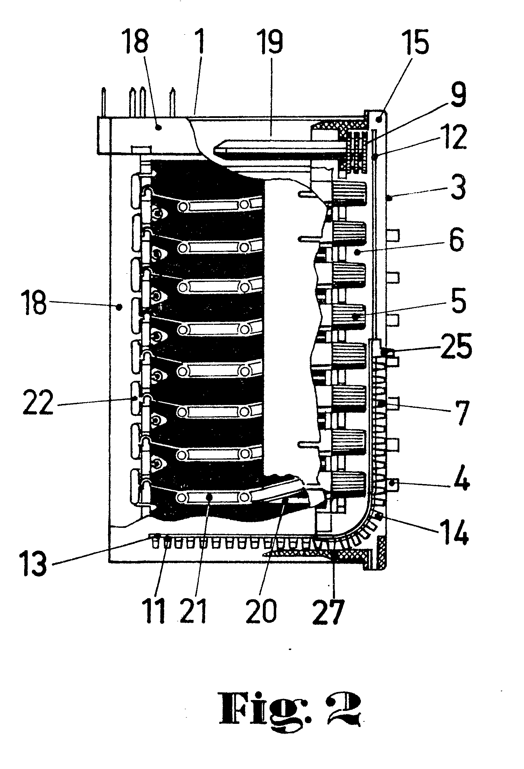

Hinter den Drucktasten 4 ist das eigentliche Speichergehäuse 18 angeordnet, wie aus Fig. 2 zu entnehmen ist. In diesem befinden sich Spindelwiderstände, die die Kanalspeicher darstellen. Diese bestehen jeweils aus einer Spindel, auf der ein Federträger entlanggeführt ist, auf dem eine Schleiffeder befestigt ist, die zwischen Widerstand und Spindel eine elektrische Verbindung herstellt. Durch die Stellung des Federträgers wird die Abstimmspannung eingestellt. Die einzelnen Widerstände sind nebeneinander auf einer Isolierstoffplatte aufge

bracht, die im Speichergehäuse gehaltert ist. An einem Ende weist jede Spindel einen Druckdrehknopf 5 auf, der in die Vertiefung 6 der Gehäusefrontseite 3 ragt und der mit einer geriffelten oder sonstwie griffig gestalteten Randung — falls Handbedienung ohne Hilfsmittel erfolgt — versehen ist. Der Druckdrehknopf 5 ist außerdem mit einer Höhlung versehen, die ein bestimmtes Innenprofil besitzt.

Der jeweilige Federträger der Spindelwiderstände besitzt einen angeformten Zapfen, der durch eine längliche Ausnehmung 20 im Speichergehäuse 18 in ein in Fig. 2 nicht sichtbares Langloch eines Anzeigeorganes hineinragt. Dieses Langloch erstreckt sich über den ganzen Abstimmbereich. Das Anzeigeorgan selbst besteht aus auslenkbaren Anzeigezungen 21, die im Bereich der Einstellstrecke dieses Langloch besitzen und die an einem Ende an einer Befestigungsschiene 22 einstückig angeformt und angelenkt sind. Diese Befestigungsschiene ist für alle Anzeigezungen gemeinsam und sie ist mit Hilfe von Schnappverbindungen im Speichergehäuse 18 gehalten. Das andere Ende ist abgewinkelt, wobei diese Abwinkelung in einer Aussparung 23 in der Vertiefung 6 der Gehäusefrontseite sichtbar ist. Das Langloch selbst ist leicht gekrümmt, so daß die Anzeigezungen — je nach Stellung des Federträgers — ausgelenkt werden. Hierdurch ist es leicht möglich, die jeweilige Stellung des Federträgers und damit die eingestellte Abstimmspannung anzeigen zu können.

Um die Stellung der Drucktasten auch aus der Ferne besser erkennen zu können, kann das Drucktastenaggregat mit einer zusätzlichen Leuchtanzeigeeinrichtung versehen werden. Diese kann z. B. aus mehreren Lichtleitern bestehen, die sternförmig von einem Leuchtzentrum aus zu den einzelnen Drucktasten hin geführt sind und deren Enden in einem Fenster 24 der Gehäusefrontseite sichtbar sind. Das Leuchtzentrum selbst besteht aus einer Fassung aus durchsichtigem Kunststoff, in derem Hohlraum eine Lampe eingesetzt ist. Die Enden der Lichtleiter, die zu den Drucktasten führen, besitzen Lichtstrahlenunterbrechungsmittel, wobei bei nicht gedrückter Drucktaste die Lichtstrahlen unterbrochen sind, so daß die in den Fenstern sichtbaren Enden dunkel sind.

Da die Einstell- und Anzeigeorgane im Normalbetrieb des Gerätes nicht unmittelbar zugänglich sein sollen, befinden sich diese in der Vertiefung 6 der Gehäusefrontseite 3. Diese Vertiefung ist durch eine Abdeckung verdeckt. Hierdurch soll eine unwissentliche oder unbeabsichtigte Fehlbedienung des Gerätes vermieden werden. Die Abdeckung kann ein starrer Schieber oder auch eine Klapptür sein. Bei dem in den Figuren dargestellten Ausführungsbeispiel wurde ein flexibles Jalousieband 7 gewählt, das in der Gehäusefrontseite beim Verschieben umgelenkt wird.

Um das Jalousieband 7 überhaupt verschieben zu können, ist es mit einer Betätigungshand

habe 25 versehen. Ferner besitzt die Gehäusefrontseite eine Einführungsöffnung 15 für das Band. Die Führung für das Band in der Gehäusefrontseite ist im übrigen eine Nut-Steg-Führung. Hierzu ist am Rand der Vertiefung beidseitig ein Steg 12 angeformt.

Das flexible Jalousieband 7 besteht aus einem länglichen Basisteil 13, an dem senkrecht zur Verschieberrichtung liegende Rippen 14 angeformt sind. Die Höhe der Rippen ist so bemessen daß deren Oberfläche mit der Gehäusefrontseite fluchtet. Damit wird optisch ein günstiges Aussehen erreicht. Seitlich besitzen die Rippen Ausnehmungen 11, in die der Steg 12 der Gehäusefrontseite hineinragt. Auf diese Weise entsteht eine Nut-Steg-Führung für das Band. Der Steg 12 macht an der der Eintrittsöffnung entgegengesetzten Seite einen Bogen von der Frontseite weg. Ferner ist an der Unterseite der Gehäusefrontseite ein Wandabschnitt 27 angeformt. Wird das Band nach unten verschoben, so wird es am Bogen umgelenkt und zwischen dem Wandabschnitt 27 und dem Speichergehäuse lose geführt. Der Bogen stellt somit das Umlenkmittel für das Band dar. Um das Band besser in die Führung einbringen zu können, ist der Bogen am Anfang leicht abgerundet und spitz zulaufend.

Wie bereits erwähnt, ist der Druckdrehknopf 5 mit einer Höhlung versehen, die ein kreuzförmiges Innenprofil besitzt. Zur Abstimmung wird ein Steckschlüssel in diese Höhlung gesteckt, der erfindungsgemäß gleichzeitig der Schaltstößel 19 für einen AFC-Schalter ist. Mit dem Schaltstößel können außerdem auch die Schaltorgane für die Frequenzbereichswahl betätigt werden. Hierzu muß der Druckdrehknopf lediglich gedrückt und anschließend in eine der Schaltposition gedreht werden.

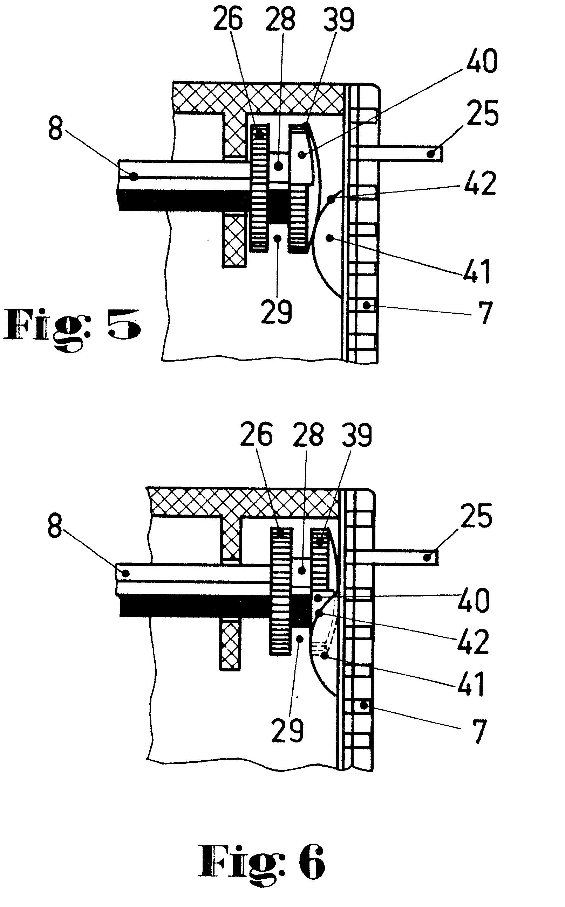

Der aus Kunststoff hergestellte Schaltstößel 19 selbst besteht aus einer Schaltstange 8 und einem angeformten Betätigungskopfteil 9. Dieser besitzt einen wesentlich größeren Durchmesser als die Schaltstange, womit insgesamt ein bequemeres Verdrehen des Druckdrehknopfes gegeben ist. Zur Führung der im Querschnitt ein kreuzförmiges Profil aufweisenden Schaltstange im Drucktastenaggregat ist im Speichergehäuse 18 eine ebenfalls kreuzförmige Führungsnut 16 vorgesehen. Der Betätigungskopfteil 9 ist am Rand geriffelt oder sonstwie griffig gestaltet. Damit ist in Verbindung mit dem relativ großen Durchmesser eine genaue und feine Abstimmung der Abstimmspannung möglich. Der Betätigungsknopf selbst besteht, wie aus den Fig. 5 und 6 hervorgeht, aus mindestens zwei Scheiben 26, die durch ein Verbindungsstück 28 mit geringem Durchmesser miteinander verbunden sind. Dadurch entsteht eine Ringnut 29, die ein besseres Herausziehen des Schaltstößels 19 aus dem Gehäuse erlaubt durch ein Eingreifen der Finger oder besser gesagt der Fingernägel in diese Ringnut. Das in den Figuren dargestellte Ausführungsbeispiel eines Schaltstößels weist zwei Scheiben auf. Selbstverständlich können auch mehr als zwei Scheiben vorhanden sein.

Jeweils endseitig die letzte Scheibe ist ballig ausgebildet, um ein leichteres Aufschieben des geführten Jalusiebandes auf den Schaltstößel und damit ein Einschieben des Schaltstößels in das Gehäuse zur Betätigung des AFC-Schalters 30 zu ermöglichen.

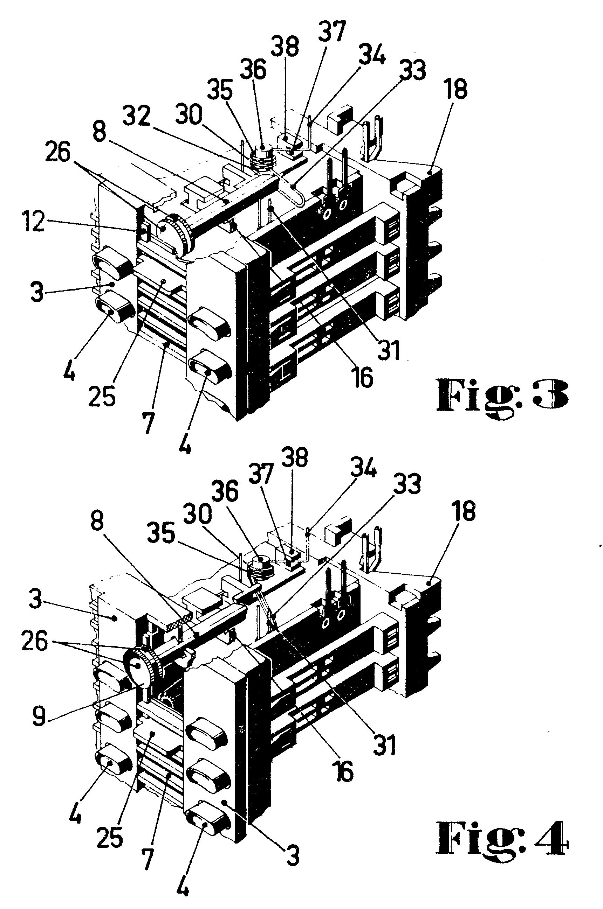

Dieser AFC-Schalter 30 besteht wie aus den Fig. 3 und 4 ersichtlich ist, aus einem ersten ortsfesten Kontaktstück 31, das aus Draht hergestellt ist. Ebenfalls aus Draht hergestellt ist das zweite Kontaktstück 32. Dieses zweite Kontaktstück ist zweiarmig ausgebildet, wobei ein Arm von dem schwenkbaren Kontaktelement 33 gebildet wird. Dieses Kontaktelement dient neben der Kontaktierung noch dazu, den Schaltstößel beim Verschieben des Jalousiebandes aus dem Gehäuse soweit herauszudrükken, daß er bequem mit dem Finger durch Eingreifen des Fingernagels in die Ringnut ganz herausgezogen werden kann. Der andere Arm wird durch das ortsfeste Anschlußstück 34 gebildet. Beide Arme sind durch ösenförmige Windungen 35 miteinander verbunden, die um einen angeformten Zapfen 36 liegen, der eine Art Widerlager für das zweite Kontaktstück darstellt. Darüber hinaus stützt sich das ortsfeste Anschlußstück 34 noch in einem Schlitz 37 einer angeformten Halterung 38 ab. Fig. 3 zeigt den AFC-Schalter in der Stellung »EIN«, während in der Fig. 4 die Stellung »AUS« dargestellt ist. Immer dann, wenn die Abstimmspannung mit Hilfe des Schaltstößels neu eingestellt wird, wird durch die Herausnahme des Schaltstößels aus dem Gehäuse der AFC-Schalter ausgeschaltet. Ist das Jalousieband jedoch geschlossen, so ist der AFC-Schalter eingeschaltet, so daß die automatische Frequenzregelung wirksam werden kann.

Sind nun zwei Speichergehäuse mit zwei Reihen von Druckdrehknöpfen vorhanden und soll eine Abstimmung in der Reihe vorgenommen werden, in der sich kein AFC-Schalter befindet, so muß, will man als Hilfsmittel zum Drehen der Druckdrehknöpfe den Schaltstößel verwenden, in der anderen Reihe das Jalousieband soweit verschoben werden, daß der Schaltstößel herausgezogen werden kann und damit befindet sich der AFC-Schalter in der Stellung »AUS«.

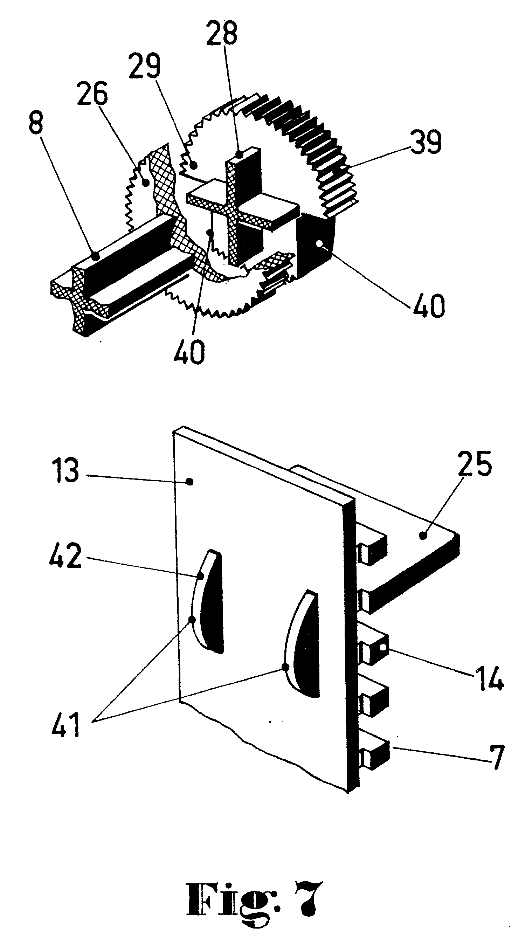

Eine andere Ausführungsform des Schaltstößels ist in den Fig. 5 bis 7 dargestellt. Zumindest die endseitige Scheibe 39 weist — wie aus dem oberen Bild der Fig. 7 hervorgeht — in eine Kreishälfte zwei gegenüberliegende Einschnitte 40 auf. Diese Einschnitte sind als V-förmige Kreisausschnitte ausgebildet und besitzen jeweils einen rechten Winkel. Außerdem sind sie so angeordnet, daß je ein gerader Rand eines Einschnittes parallel zum Rand des anderen Einschnittes verläuft. Diese Einschnitte wirken mit Ansätzen 41 zusammen, die sich auf der Innenseite des Jalousiebandes befinden. Ist der Schaltstößel nun so eingesteckt, daß sich die Einschnitte entsprechend Fig. 6 unten befinden, d. h. zu der Druckdrehknopfreihe hin, so ragen die Ansätze 41 in diese Einschnitte 40, so daß der AFC-Schalter sich in der Stellung »AUS« befindet, obwohl das Jalousieband ganz nach oben geschoben ist. Will man erreichen, daß·der AFC-Schalter die Stellung »EIN« einnimmt, so ist es lediglich erforderlich, den Schaltstößel um 180 Grad gedreht in das Gehäuse einzuschieben. Schiebt man das Jalousieband dann nach oben, so laufen die Ansätze 41 mit ihren Anschrägungen 42 auf die auf der Oberfläche ballig geformte Scheibe 39 auf und sie schieben den Schaltstößel nach hinten, so daß der AFC-Schalter in die Stellung »EIN« übergeht. Durch diese im zweiten Ausführungsbeispiel des Schaltstößels ergriffenen konstruktiven Maßnahmen ist es so leicht möglich, bei geschlossenem Jalousieband beide Stellungen des AFC-Schalters wahlweise verwirklichen zu können.

Nicht in den Figuren dargestellt ist die Ausführungsform, bei der die Vertiefung durch eine Klapptür bedeckt ist. Will man auch hier die Wahlmöglichkeit für den AFC-Schalter haben, so können an der Klapptür ein oder zwei vorstehende Zapfen angeformt sein, die je nach Stellung des Schaltstößels mit einem oder mehreren Einschnitten oder mit der endseitigen Scheibe zusammenwirken.

## Patentansprüche

1. Drucktastenaggregat für Empfangsgeräte der Nachrichtentechnik, insbesondere für Fernsehempfänger, mit sich gegenseitig auslösenden Drucktasten (4) zur Einschaltung einspeicherbarer, wahlweise einstellbarer elektrischer Werte von aus mehreren Spannungsteilern für Kapazitätsdiodenabstimmung bestehenden Kanalspeichern, mit den jeweiligen Drucktasten (4) zugeordneten, mit einem gesondert vorhandenen Werkzeug drehbaren, axial verschiebbaren und hinter einer Abdeckung (7) in einer Vertiefung (6) verborgenen Druckdrehknöpfen (5) zur Kanalabstimmung und bedarfsweise zur Auswahl eines Frequenzbereiches, der in einer von der Abstimmstellung verschiedenen Stellung des Druckdrehknopfes (5) durch Drehen in verschiedene rastende Winkelstellungen einstellbar ist, und mit einem Schalter (30), der mit Hilfe eines Schaltstößels (19) bedarfsweise durch die Abdeckung (7) betätigbar ist, dadurch gekennzeichnet, daß der herausnehmbare Schaltstößel (19) gleichzeitig Werkzeug zum Drehen der Druckdrehknöpfe (5) ist.

2. Drucktastenaggregat nach Anspruch 1, dadurch gekennzeichnet, daß der Schaltstößel (19) aus einer Schaltstange (8) und einem angeformten Betätigungskopfteil (9) besteht, dessen Durchmesser ein mehrfaches der Schaltstange beträgt.

3. Drucktastenaggregat nach Anspruch 2, dadurch gekennzeichnet, daß die Schaltstange (8) im Querschnitt ein kreuzförmiges Profil aufweist und im Gehäuse des Drucktastenaggregates eine kreuzförmige Führungsnut (16) zur Aufnahme der axial verschiebbaren Schaltstange vorhanden ist.

4. Drucktastenaggregat nach Anspruch 2, dadurch gekennzeichnet, daß der Betätigungskopfteil (9) eine geriffelt oder sonstwie griffig gestaltete Randung besitzt.

5. Drucktastenaggregat nach einem der Ansprüche 1 bis 4, dadurch gekennzeichnet, daß der Betätigungskopfteil (9) aus mindestens zwei parallel angeordneten Scheiben (26) besteht, die jeweils durch ein Verbindungsstück (28) mit geringerem Durchmesser untereinander verbunden sind, so daß Ringnuten (29) gebildet werden.

6. Drucktastenaggregat nach einem der Ansprüche 1 bis 5, dadurch gkennzeichnet, daß der Schalter aus einem ersten ortsfesten Kontaktstück (31) und einem an einem Widerlager des Drucktastenaggregates gehalterten zweiarmigen zweiten Kontaktstück (32) besteht, dessen einer Arm als durch den Schaltstößel schwenkbares Kontaktelement (33) und dessen anderer Arm als ortsfestes Kontaktstück (34) ausgebildet ist.

7. Drucktastenaggregat nach Anspruch 6, dadurch gekennzeichnet, daß das erste und zweite Kontaktstück (31, 33) aus Draht hergestellt sind und daß das Widerlager des zweiten Kontaktstücks von einem an das Drucktastenaggregat angeformten Zapfen (36) gebildet wird, um den ösenförmige Windungen (35) des zweiten Kontaktstückes (32) liegen.

8. Drucktastenaggregat nach einem der Ansprüche 1 bis 7, dadurch gekennzeichnet, daß die Abdeckung ein im Drucktastenaggregat verschiebbares Jalousieband (7) ist.

9. Drucktastenaggregat nach einem der Ansprüche 1 bis 7, dadurch gekennzeichnet, daß die Abdeckung eine schwenkbare Tür ist.

10. Drucktastenaggregat nach einem der Ansprüche 1 bis 8, dadurch gekennzeichnet, daß die endseitige Scheibe (39) des Betätigungskopfteils (9) zwei in einer Kreishälfte gegenüberliegende Einschnitte (40) aufweist, in die jeweils ein auf der Innenseite des Jalousiebandes (7) angeformter, mit einer Anschrägung (42) versehener Ansatz (41) eingreifen kann, sofern der Schaltstößel (19) so eingesteckt ist, daß beide Einschnitte (40) zu der Druckdrehknopfreihe hin liegen.

11. Drucktastenaggregat nach Anspruch 10, dadurch gekennzeichnet, daß die Einschnitte (40) als V-förmige Kreisausschnitte mit einem rechten Winkel ausgebildet sind, die so nebeneinander liegen, daß der eine Rand des ersten Einschnittes zu einem Rand des zweiten Einschnittes parallel verläuft.

## Claims

1. Push button unit for receiving devices in the field of communications, in particular for television receivers, with mutually releasing push buttons (4) for switching on electrical values from channel stores comprising a plurality of potentiometers for capacitance diode tuning, which values are optionally adjustable and can be stored, with push button knobs (5) associated with the respective push buttons (4), which are axially displaceable and can be rotated with a separately existing tool and are concealed in a recess (6) behind a cover (7), for channel tuning and if necessary for the selection of a frequency range which can be adjusted in a position of the push button knob (5) which is different from the tuning position by rotation into different locating angular positions, and with a switch (30) which can be actuated with the aid of a switching rod (19) if necessary through the cover (7), characterised in that the removable switching rod (19) is at the same time a tool for turning the push button knobs (5).

2. Push button unit according to claim 1, characterised in that the switching rod (19) consists of an operating bar (8) and a moulded-on actuating head part (9), the diameter of which is a multiple of the operating bar.

3. Push button unit according to claim 2, characterised in that the operating bar (8) in cross section has a cruciform profile and in the housing of the push button unit there is a cruciform guide groove (16) for receiving the axially displaceable operating bar.

4. Push button unit according to claim 2, characterised in that the actuating head part (9) has a milled or otherwise easy-to-grip edge.

5. Push button unit according to one of claims 1 to 4, characterised in that the actuating head part (9) comprises at least two discs (26) arranged in parallel which are respectively joined to one another by a connecting piece (28) with a smaller diameter, so that annular grooves (29) are formed.

6. Push button unit according to one of claims 1 to 5, characterised in that the switch comprises a first fixed contact piece (31) and a two-armed second contact piece (32) mounted on an abutment of the push button unit, the one arm of which is formed as a contact element (33) which can be rotated by the switching rod, and the other arm of which is formed as a fixed contact piece (34).

7. Push button unit according to claim 6, characterised in that the first and second contact pieces (31, 33) are made of wire and in that the support of the second contact piece is formed by a pin (36) moulded on to the push button unit, around which pin lie ring-shaped turns of the second contact piece (32).

8. Push button unit according to one of claims 1 to 7, characterised in that the cover is a louvred strip (7) which is displaceable in the push button unit.

9. Push button unit according to one of claims 1 to 7, characterised in that the cover is a tiltable door. ·

10. Push button unit according to one of claims 1 to 8, characterised in that the end-side disc (39) of the actuating head part (9) has two recesses (40) lying opposite each other in a semi-circle, into which a projection (41) provided with a facet (42) moulded on the inner side of the louvred strip (7) can respectively engage, so long as the switching rod (19) is so inserted that both recesses (40) lie in the direction of the row of push button knobs.

11. Push button unit according to claims 10, characterised in that the recesses (40) are formed as V-shaped segments of a circle with a right angle, which lie next to one another in such a way that the one edge of the first recess runs parallel to one edge of the second recess.

## Revendications

1. Dispositif de commande à touches pour des appareils récepteurs de la technique de communication, notamment pour des récepteurs de télévision, comportant des touches (4) se déclenchant mutuellement pour établir des valeurs électriques, réglables sélectivement, pouvant être mémorisées, de mémoires de canaux se composant de plusieurs diviseurs de tension pour un accord de diodes capacitives, des boutons-poussoir tournants (5), associés aux touches correspondantes (4), pouvant être tournés à l'aide d'un outil prévu spécialement, pouvant coulisser axialement et masqués en arrière d'un couvercle (7) dans une partie en creux (6), ces boutons servant, à l'accord des canaux et en cas de besoin à une sélection d'une gamme de fréquences, qui peut être réglée dans une position, différente de la position d'accord, du bouton-poussoir tournant 5 par rotation dans différentes positions angulaires d'arrêt, ainsi qu'un commutateur (30) qui peut être actionné au moyen d'un poussoir de commande (19) en cas de besoin par le couvercle (7), caractérisé en ce que le poussoir de commande (19), pouvant être sorti, constitue simultanément un outil pour faire tourner les boutons-poussoirs tournants (5).

2. Dispositif de commande à touche selon la revendication 1, caractérisé en ce que le poussoir de commande (19) se compose d'une tige de commande (8) et d'une partie profilée (9) formant une tête d'actionnement et dont le diamètre s'élève à un multiple de celui de la tige de commande.

3. Dispositif de commande à touches selon la revendication 2, caractérisé en ce que la tige de commande (8) a en section droite un profil en forme de croix et en qu'il est prévu dans le carter du dispositif de commande à touches une rainure de guidage (16) en forme de croix pour recevoir la tige de commande pouvant coulisser axialement.

4. Dispositif de commande à touches selon la revendication 2, caractérisé en ce que la partie (9) formant la tête d'actionnement comporte un bord strié ou autrement rendu non glissant.

5. Dispositif de commande à touches selon l'une des revendications 1 à 4, caractérisé en ce que la partie (9) formant la tête d'actionnement se compose d'au moins deux disques (26) disposés parallèlement et qui sont reliés entre eux par une pièce de liaison (28) de plus petit diamètre de manière à former des goges (29).

6. Dispositif de commande à touches selon l'une des revendications 1 à 5, caractérisé en ce que le commutateur se compose d'une première pièce de contact fixe (31) et d'une seconde pièce de contact (32) à deux branches, qui est maintenue sur un contre-appui du dispositif de commande à touches, une des branches étant agencée sous forme d'un élément de contact (33) pouvant être tourné par le bouton-poussoir de commande tandis que l'autre branche est agencée sous la forme d'une pièce de contact fixe (34).

7. Dispositif de commande à touches selon la revendication 6, caractérisé en ce que les première et seconde pièces de contact (31, 33) sont fabriquées en fil métallique et en ce que le contre-appui de la seconde pièce de contact est constitué par un téton (36) profilé sur le dispositif de commande à touches et autor duquel sont placées des spires en forme d'oreilles (35) de la seconde pièce de contact (32).

8. Dispositif de commande à touches selon l'une des revendications 1 à 7, caractérisé en ce que le couvercle est une bande à ouies (7) qui est déplaçable par translation dans les dispositifs de commande à touches.

9. Dispositif de commande à touches selon l'une des revendications 1 à 7, caractérisé en ce que le couvercle est un volet pivotant.

10. Dispositif de commande à touches selon l'une des revendications 1 à 8, caractérisé en ce que le disque extrême (39) de la partie (9) formant tête d'actionnement comporte deux encoches (40) placées dans des positions opposées sur un demi-cercle et dans chacune desquelles peut s'engager un appendice (41), formé sur le côté intérieur de la bande à ouies (7) et pourvu d'un chanfrein (42), pour autant que le poussoir de commande (19) soit engagé de telle sorte que les deux encoches (40) viennent se placer en regard de la rangée de boutonspoussoirs tournants.

11. Dispositif de commande à touches selon la revendication 10, caractérisé en ce que les encoches (40) sont agencées sous forme de secteurs circulaires en forme de V correspondant à un angle droit et qui sont placés l'un à côté de l'autre de telle sorte qu'un des bords de la première encoche soit orienté parallélement à un bord de la seconde encoche.

**Fig. 1**

**Fig. 2**

Fig. 3

Fig. 4

**Fig: 5**

**Fig: 6**

# Fig. 7